Europäisches Patentamt

European Patent Office

Office européen des brevets

(11) Veröffentlichungsnummer: **0 252 541**
**A1**

(12) **EUROPÄISCHE PATENTANMELDUNG**

(21) Anmeldenummer: **87201000.4**

(22) Anmeldetag: **27.05.87**

(51) Int. Cl.³: **H 02 H 3/087**

(30) Priorität: **07.07.86 NL 8601761**

(43) Veröffentlichungstag der Anmeldung:
**13.01.88 Patentblatt 88/2**

(84) Benannte Vertragsstaaten:
**AT BE CH DE ES FR GB GR IT LI LU NL SE**

(71) Anmelder: **Venema, Tjeerd**
**Brigantijnstraat 55**
**NL-1503 BR Zaandam(NL)**

(72) Erfinder: **Venema, Tjeerd**
**Brigantijnstraat 55**
**NL-1503 BR Zaandam(NL)**

(54) **Elektronisch gesteuerter elektrischer Stromsicherungsautomat.**

(57) Bei einem elektrischen Stromsicherungsautomat für Gleichstrom, Wechselstrom oder Drehstrom wird für die Stromunterbrechung, die für die Sicherungsfunktion notwendig ist, ein Transistor (2) verwendet, durch den der zu überwachende und zu sichernde Strom fliesst und wobei der genannte Transistor (2) analog auf Spitzenstrom und/oder Kurzschlussstrom gesichert wird mit Hilfe von minimal einem Spitzenstromsensor (7) und einem Komparator (21) und wobei der genannte Spitzenstromsensor (7), direkt oder indirekt, den genannten Komparator (21) ansteuert und wobei der Komparator (21), direkt oder indirekt, den genannten Transistor (2) ansteuert und wobei dieser Transistor (2) ebenfalls versehen ist mit einer elektronischen effektiven Stromabschaltfunktion, die minimal aus einem effektiven Stromsensor (4), einem Integrator (10), einem zweiten Komparator (12) und einem Zeitstromkreis (14) besteht, wobei der genannte effektive Stromsensor (4), direkt oder indirekt, den genannten Integrator ansteuert und der genannte Integrator (10), direkt oder indirekt, den genannten zweiten Komparator (12) ansteuert und der genannte zweite Komparator (12), direkt oder indirekt, den genannten Zeitstromkreis (14) ansteuert und wobei, während der Aktivierungszeit des Zeitstromkreises (14), dieser Stromkreis, direkt oder indirekt, dafür sorgt, dass der genannte Transistor zeitweilig sperrt, um damit die effektive Stromsicherung arbeiten zu lassen und auch dem Transistor (2) genügend Zeit zu geben, um im zeitweiligen gesperrten Zustand, thermisch abzukühlen.

FIG. 1

Croydon Printing Company Ltd

## ELEKTRONISCH GESTEUERTER ELEKTRISCHER STROMSICHERUNGSAUTOMAT.

Es sind verschiedene Stromsicherungen auf dem Markt. Die meisten arbeiten auf thermische Weise. Einer der Nachteile der elektrischen Stromsicherungen, in Bezug auf Elektronikschaltungen, ist ihre Trägheit. Vor allem Halbleiter in den Schaltungen sind schneller defekt, als eine angebrachte Stromsicherung reagiert. In der Elektronik hat man nach einer Sicherung, mit der gleichen bzw. schnelleren Geschwindigkeit, als die Schaltgeschwindigkeit der Halbleiter, gesucht. Leider ist eine solche Sicherung bis vor kurzer Zeit nicht auf den Markt gebracht worden, da bipolare Transistoren nicht für eine elektronisch gesteuerte Sicherung geeignet sind. Der Einsatz von sogenannten Powermostransistoren eignet sich jedoch hierfür hevorragend, da diese Transistoren den Stromfluss schneller unterbrechen, als Elektronikschaltungen darauf reagieren können. Die hier beschriebene Erfindung ist ein elektronisch gesteuerter elektrischer Sicherungsautomat und universal anwendbar. Die Anwendungsmöglichkeiten dieses Stromsicherungsautomaten sind wie folgt: selbständige Stromsicherung für Wechselspannungs-, Gleichspannungs- und Drehstromnetze. Andererseits kann der elektronisch gesteuerte elektrische Stromsicherungsautomat als Stromsicherung in Elektronikschaltungen integriert werden. Durch die hohe Reaktionsgeschwindigkeit sichert dieser Automat nicht nur Elektronikschaltungen und Netze, sondern sich auch selbst. Das Anwendungsgebiet dieses elektronisch gesteuerten elektrischen Stromsicherungautomaten als Stromsicherung ist nahezu unbegrenzt. Ein weiterer Vorteil dieses Automaten ist seine grosse Genauigkeit. Stromschalttoleranzen von einigen Prozenten sind realisierbar. Weiterhin kann dieser Stromsicherungsautomat im Bereich von milli-Ampere bis kilo-Ampere eingesetzt werden. Der Spannungsbereich erstreckt sich ab einigen Volt bis zu Spannungen von 1000 Volt und mehr.

Die Erfindung wird mit Hilfe von sieben Figuren besprochen werden.

Figur 1. gibt das allgemeine blockschematische Prinzip.
Figur 2. gibt eine Variante von Figur 1 mit einer bistabilen Ein- und Ausschaltfunktion.
Figur3. gibt das blockschematische Prinzip, erweitert mit einer galvanischen Stromtrennung.

Figur 4. gibt eine praktische Anwendung der Erfindung für Gleichstrom.

Figur 5. gibt eine praktische Anwendung für Gleichstrom, erweitert mit einer galvanischen Trennung.

Figur 6. gibt ein zusätzliches Schaltbild für Wechselstromanwendungen, bei dem die Schaltung laut Figur 1 bis einschliesslich Figur 5, oder eine Variante davon, verwendet werden kann.

Figur 7. gibt eine Wechselstromanwendung, bei der zwei Schaltungen laut Figur 1 bis einschliesslich Figur 5, oder eine Variante davon, verwendet werden kann.

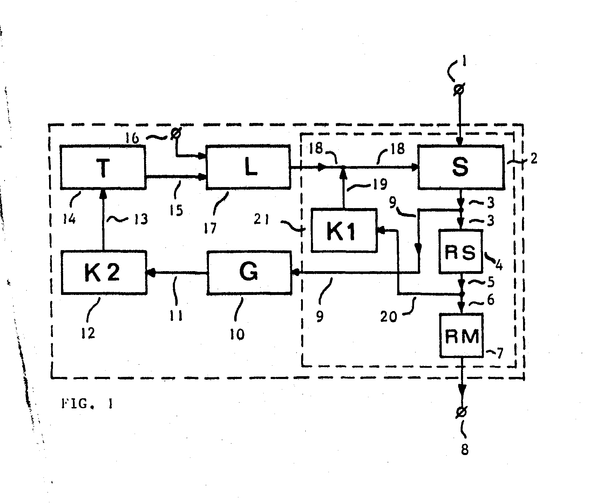

Figur 1 gibt blockschematisch das Prinzip des elektronisch gesteuerten elektrischen Stromsicherungsautomaten wieder. 1 bis 8 kann an einer Gleichstromleitung angeschlossen werden, um den Strom zu sichern. 2 stellt in Figur 1 einen elektronischen Schalter dar. In diesem Fall ist das ein Powermostransistor. Kennzeichnend für diese Transistoren ist das Führen kurzzeitiger relativ hohen Spitzenströme. Durch den extrem niedrigen Ubergangswiderstand können die Verluste, mit 2, gering gehalten werden. Um diese Transistoren, durch überschreiten des maximal zulässigen Spitzenstromes (von 2), vor Zerstörung zu schützen, ist in Figur 1 eine analoge Spitzenstrombegrenzung angebracht. Dieser Spitzenstrom wird mit dem Serienwiderstand 7 gemessen. Der zu sichernde Strom in Figur 1 fliesst über 1 nach 2 und dann über 3 nach 4 und weiter nach 5,6 und 7 und kommt über 8 zum Ausgang. Der Strom durch 1 ist somit gleich dem Strom durch 8. Der Strom zwischen 1 und 8 wird in 7 in ein Spannungsniveau umgewandelt, das über 6 und 20 auf 21 steht. 21 stellt einen Komparator (K1) dar. Wenn der Strom zwischen 1 und 8 einen bestimmten Spitzenstrom überschreitet, reagiert 21 so, dass über 19 eine Signaländerung auf 18 erfolgt. Dadurch wird im Transistor 2 analog der Strom begrenzt. Diese analoge Strombegrenzung über 21 ist notwendig, um eine hohe Spitzenstrombegrenzungsgeschwindigkeit des Stromes zwischen 1 und 8 garantieren zu können. Dadurch wird Transistor 2 geschützt. In der Praxis kann der Stromkreis für die analoge Spitzenstrombegrenzung (21) im Nanosekundenbereich analog arbeiten. Dies geschied so schnell, dass eine Zerstörung von Transistor 2, durch plötzliche Spitzen- oder Kurzschlussströme, ausgeschlossen ist. Ausser der genannten analogen Strombegrenzung über 2, erfolgt eine zweite Stromüberwachung in Figur 1. Hier wird die Strommessung durch den Stromzweig von 1 nach 8 genutzt. In diesem Fall besteht diese zweite Strommessung aus der Serienschaltung durch Widerstand 4 und 7. Durch den Stromfluss von 1 nach 8 wird eine Spannung über Widerstand 4 erzeugt und durch den Stromfluss durch Widerstand 4 plus 7 und 8 als Spannungsreferenzniveau, steht auf 3 eine Spannung. Diese Spannung steht, über 9 am Integrator 10. Damit der Sicherungsautomat nicht zu schnell reagiert, ist der Integrator 10 installiert. Die analoge Strombegrenzung über 21 ist notwendig, damit Transistor 2 vor Zerstörung durch grosse Spitzen- oder Kurzschlussströme (zwischen 1 und 8) geschützt wird. Eventuell kann diese analoge Strombegrenzung über 21 auch Vorteile als Spitzenstrombegrenzung für den zu sichernden externen Stromkreis erbringen. Dies ist eine sekundäre Angabe. Integrator 10 muss dafür sorgen, dass der Stromsicherungsautomat über Transistor 2, nicht zu schnell den Strom zwischen 1 und 8 unterbricht. Kurze Pulsströme zwischen 1 un 8 würden sonst das gut Funktionieren des Sicherungsautomaten schaden. Die Integrationskonstante von 10 muss klein gewählt werden, damit eine eventuelle anwesende analoge Spitzenstrombegrenzung über 21 nicht zur Folge hat, den Transistor 2 thermisch zu überlasten und somit das Substrat zu zerstören. Spitzenströme durch Transistor 2 dürfen meistens nur ein paar hundert Microsekunden dauern. Bevor die maximale analoge Spitzenstrombegrenzungszeit über 21 überschritten wird, muss der Integrator 10 eine Steuerung auf 11 gegeben haben. Über 11 wird ein zweiter Komparator 12 gesteuert. Komparator 12 wird nach Aktivierung sofort über 13 einen Zeistromkreis 14 ansteuern. 14 wird jetzt über 15 sofort die Schaltlogik 17 ansteuern und dafür sorgen, dass die Steuerung vom Transistor 2 über 18 weggenommen wird. Dadurch wird Transistor 2 sofort öffnen. Solange die Aktivierungszeit des Zeitstromkreises 14 aktiv ist, wird 2 geöffnet sein. Dabei ist die Aktivierungszeit, während 14 aktiv ist, so gewählt worden, dass die Zeit genügt, um 2 im geöffneten Zustand abkühlen zu lassen. Wenn die Aktivierungszeit von 14 (automatisch) beendet ist, wird über 15, 17 und 18 Transistor 2 wieder geschlossen, sodass wieder ein Strom zwischen 1 und 8 fliesst. In der Praxis kann die Aktivierungszeit von 14 ungefähr 100 Millisekunden betragen. Dies bedeutet, dass die Schaltung laut Figur 1 in diesem Fall 10 mal pro Sekunde den Strom automatisch ein- und ausschalten kann und zwar zwischen den Punkten 1 und 8, wenn hier der Strom zu gross ist.

Die Funktion des elektronisch gesteuerten elektrischen Stromsicherungsautomaten kann wie folgt zusammengefasst werden: In Figur 1 wird für einen bestimmten Grenzwert ein Strom zwischen 1 und 8 gesichert. Um den Strom zwischen 1 und 8 zu unterbrechen, ist ein Schalter 2 vorhanden. Schalter 2 ist ein schneller Powermostransistor der einen bestimmten maximalen Spitzenstrom nicht überschreiten darf. Um diesen Transistor vor Zerstörung durch Spitzen- und Kurzschlussströme zu sichern, ist eine schnelle analoge Strombegrenzung eingebaut worden. Diese arbeitet über Stromsensor 7 und dem analogen Komparator 21. Um den Strom zwischen 1 und 8 effektiv abzusichern, ist ein zweiter Stromsensor in Figur 1 angebracht worden. Dieser besteht aus der Serienschaltung durch die Widerstände 4 und 7. Dabei wird der Strom über Widerstand 4 und 7 in eine Spannung umgewandelt, die über 9 am Integrator 10 steht. Wenn während einer bestimmten maximal zulässigen Zeit, eingestellt mit 10, ein bestimmter maximal zulässiger Effektivstrom überschritten wird, wird Integrator 10 auf 11 eine Steuerung geben. Dadurch reagiert der Komparator 12 und über 13 wird der Zeitstromkreis 14 angesteuert. Während der Aktivierungszeit von 14 wird über 15, 17 und 18 Schalter 2 geöffnet. Dadurch ist der Strom zwischen 1 und 8 während der Aktivierungszeit von 14 unterbrochen. Während der Aktivierungszeit von 14 kann 2 wieder abkühlen. 14 beendet automatisch seine Aktivierungszeit, wonach über 15, 17 und 18 Transistor 2 wieder geschlossen wird. Danach fängt der Vorgang wieder von neuem an. Durch Komparator 21 wird immer analog auf Spitzen- und Kurzschlussströme begrenzt. Mit Integrator 10 und Komparator 12 wird der effektive maximal zulässige Strom zwischen 1 und 8, als eine Funktion der Zeit, überwacht. Wichtig ist in Figur 1, dass Komparator 21 kontinuierlich so schnell wie möglich, analog die Spitzen- und Kurzschlussströme durch 2 begrenzt, während Komparator 12 so schnell reagieren muss, dass eine gute effektive Stromüberwachung zwischen 1 und 8 entsteht. Die Aktivierungszeit von 14 soll so lange gewählt werden, dass 2 im geöffneten Zustand immer genügend Zeit hat, um abzukühlen. Somit bleibt er innerhalb seiner sogenannten SOAR-grenze (Save Operating Area). Der elektronisch gesteuerte elektrische Stromsicherungsautomat laut Figur 1, kann auch gleichzeitig als Stromschalter benutzt werden. Hierfür kann auf 16 ein betreffendes Niveau angeboten werden. Das Vorhandensein eines bestimmten Niveaus auf 15 und 16 hat zur Folge, dass Transistor 2 über 17 und 18 angesteuert und dadurch geschlossen wird. Wenn 16 nicht das gleiche Niveau wie 15 hat, wird Transistor 2 nicht über 17 und 18 angesteuert. In diesem Fall ist Transistor 2 geöffnet. 16 kann also, in Figur 1, benutzt werden um den Sicherungsautomaten ein- oder auszuschalten.

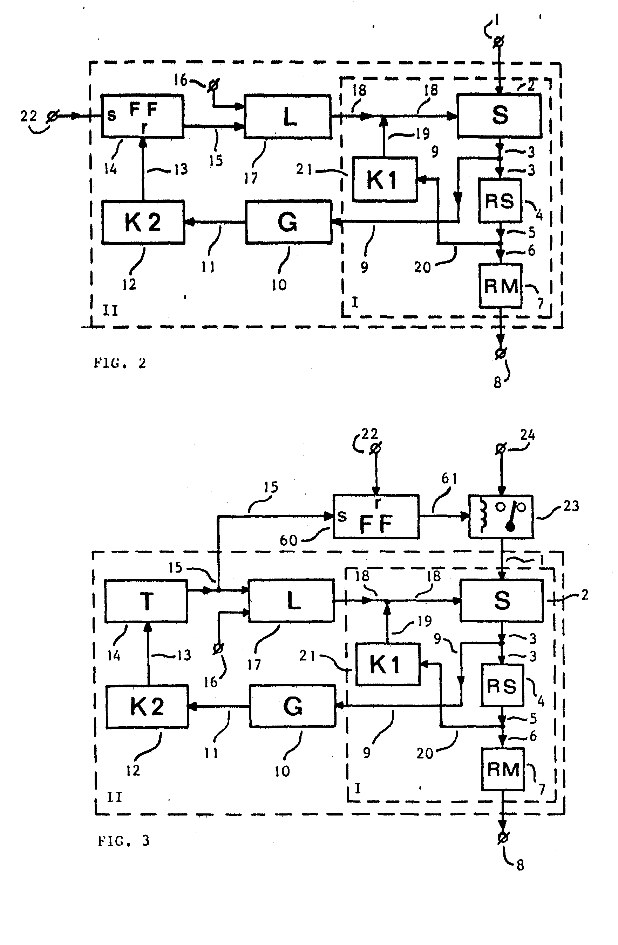

Es wird klar sein, dass mit 14 die feste, sowie die unbestimmte Aktivierungszeit von 14 digital, sowie analog generiert werden kann. Figur 2 gibt hierfür ein Beispiel. Vollständigkeitshalber soll erwähnt werden, dass bei allen Figuren alle gleichen zahlenmässigen Kodierungen stets übereinstimmen. In Figur 2 ist der Zeitstromkreis 14 ersetzt worden durch eine bistabile Schaltung (Flip-Flop). Dabei funktioniert in Figur 2 der elektronisch gesteuerte elektrische Stromsicherungsautomat mit einer Resetsteuerung ab 22. Wenn in Figur 2 der Komparator 12 über 13 die bistabile Schaltung 14 ansteuert, wird dies über 15, 17 und 18 ein permanentes öffnen von Transistor 2 zur Folge haben. Das wieder Schliessen von Transistor 2 ist jetzt möglich, wenn man über 22 ein Reset an die bistabile Schaltung 14 anbietet. Danach wird über 15, 17 und 18 Transistor 2 geschlossen. Auch in Figur 2 ist der elektronisch gesteuerte elektrische Stromsicherungsautomat als Ein- und Ausschalter zu gebrauchen. Die Steuerung hierfür kann mit einem bestimmten logischen Signal auf Punkt 16 ausgeführt werden. Abhängig von der Anwendung und/oder Schaltmethode des elektronisch gesteuerten elektrischen Stromsicherungsautomaten, kann die Steuerleitung 16 und/oder 17 von den Figuren 1 und 2 weggelassen werden, sodass in diesem Fall nur die Sicherungsfunktion vorhanden ist. Ohne die Aussteuerungsmöglichkeit ab Punkt 16, die in den Figuren gegeben ist, arbeitet die Schaltung ohne extra Schalterfunktion, nur als Stromsicherungsautomat.

Abhängig von der Anwendung des elektronisch gesteuerten elektrischen Stromsicherungsautomaten kann es notwendig sein, dass dieser mit einem galvanischen Abschaltsystem kombiniert wird, zum Beispiel ein Relais. Figur 3 gibt hierfür eine mogliche Ausführungsform. Die Schaltung in Figur 3 ist nahezu gleich Figur 1. In Figur 3 wird das galvanische Abschalten des Stromes über 15 aktiv und über 22 wieder normalisiert. Wenn Komparator 12 aktiv wird, wird über 13, 14 und 15 die bistabile Schaltung 60 umgeschaltet. Über 15, 17 und 18 wird in diesem Fall Transistor 2 geöffnet. Andererseits kommt jetzt in Figur 3 auch aus 60 eine Steuerung 61, die Relais 23 öffnet. Weil Relais 23 in Reihe mit dem Stromkreis 1 - 8 geschaltet ist, wird jetzt die Stromabschaltung zwischen 8 und 24 eine galvanische Trennung ergeben. Immerhin, zwischen 1 und 8 besteht eine elektronische Trennung durch Transistor 2 und zwischen 1 und 24 besteht eine galvanische Trennung durch Relais 23. In Figur 3 kann der Sicherungsautomat zurückgesetzt werden, wenn auf 22

0252541

eine Steuerung gegeben ist und somit die bistabile Schaltung zurückgesetzt wird. In diesem Fall schliessen 2 und 23 wieder.

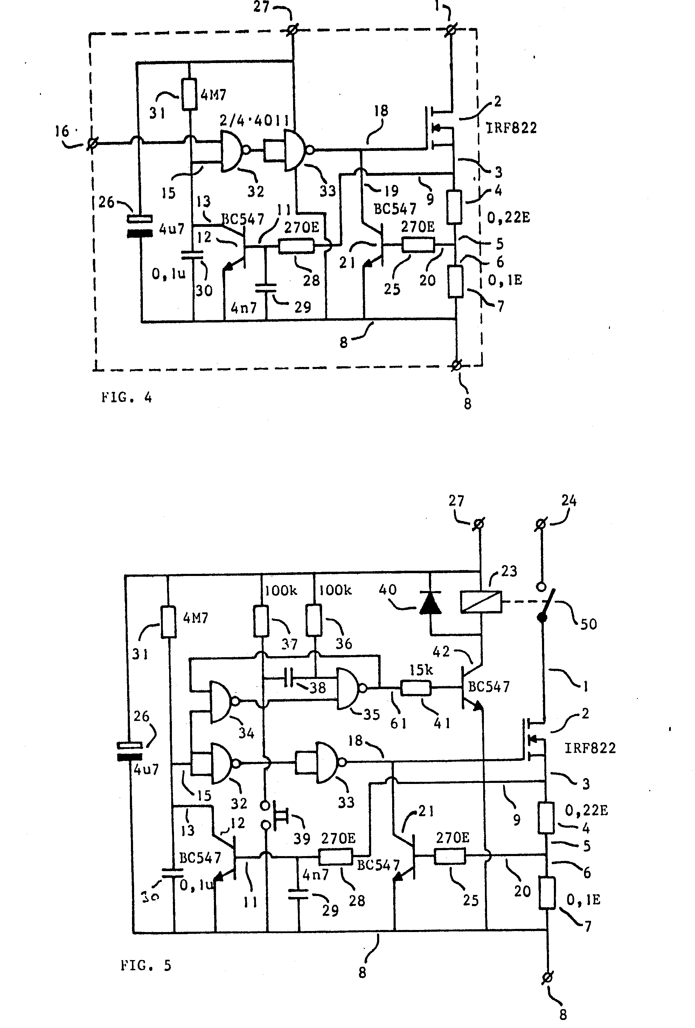

Figur 4 zeigt ein praktisches Beispiel des elektronisch gesteuerten elektrischen Stromsicherungsautomaten laut Figur 1. In Figur 4 wird ein praktischer Gleichstromsicherungsautomat gezeigt, wobei 1 Eingang und 8 Ausgang ist. 2 stellt hier wieder den elektronischen Schalter dar. Die analoge Spitzenstrombegrenzung wird hier im Komparator 21 erzeugt. Für die Spitzenstrommessung wird Widerstand 7 benutzt. Die Spannung dafür wird über Widerstand 25 am Komparator 21 angeboten. In diesem Fall besteht dieser Komparator nur aus einem Transistor. Die analoge Spitzenstrombegrenzung erfolgt im Transistor 2, wenn der Kollektor von Transistor 21 mit der Steuerelektrode 18 des Transistors 2 verbunden wird. Hier ist Transistor 2 ein Powermosfet. Mit Hilfe der Widerstände 4 und 7 erfolgt die effektive Stromsicherung. Diese geben ihre gesamte Spannung auf 9. Diese Spannung steht über Widerstand 28 am Komparator 12. Widerstand 28 und Kondensator 29 bilden in Figur 4 den Integrator 10 aus Figur 1. Der Zeitstromkreis in Figur 4 ist mit Kondensator 30 und Widerstand 31 aufgebaut. Die Schaltlogik besteht aus zwei NAND-Gatter, zum Beispiel 32 und 33. Punkt 16 kann eventuell für die genannte extra Schalterfunktion benutzt werden. Wenn diese Schalterfunktion nicht gewünscht wird, muss 15 galvanisch mit 16 verbunden werden. Die Speisung für den Schalter liegt zwischen Punkt 8 und 27. Im Prinzip wird hierbei nur geringer Strom von der Schaltung verbraucht (etwa 200 Micro-Amper). Die Speisung ist abhängig von der Schaltung und kann in verschiedener Weise aufgebaut werden. Kondensator 26 ist zur Glättung der Speisespannung. Die Schaltung laut Figur 4 ergibt eine analoge Spitzenstrombegrenzung bei ungefähr 7A mittels der Widerstände 7 und 21. Eine effektive Stromsicherung bei ca. 1,5A ergibt sich durch die Widerstände 4 und 7. Ein Effektivstrom von ca. 1,5A zwischen 1 und 8, erzeugt auf 9 eine Spannung, um über Widerstand 28 den Komparator 12 in den leitenden Zustand zu bringen. Dadurch wird die positive Spannung auf 15 bis nahezu dem Niveau von 8 abnehmen, wobei sich der Kondensator 30 entläd, wenn Komparator 12 leitend ist. Durch das abnehmende Spannungsniveau auf 15 wird die logische Einstellung von 32 und 33 geändert. Dies bedeutet, dass eine Senkung der Spannung auf 15, infolge des leitenden Zustandes von 12, ein Nullpotentional der Steuerspannung auf 18 zur Folge hat. Durch die Geschwindigkeit mit der sich Kondensator 30 entläd, hat das Senken der Spannung sowohl auf 15 als auf 18 einen schaltenden Charakter. Sobald 12 leitend ist, wird dieser innerhalb einer einzigen Microsekunde 30 ganz entladen. In nahezu der gleichen Zeit wird auf 18 die Steuerspannung für 2 gleich 0 Volt betragen. Wenn 2 geöffnet ist, beträgt die Spannung über die Widerstände 4 und 7 ebenfalls 0 Volt. Dies hat zur Folge, dass die Steuerspannung für 12 gleich 0 Volt betragt, sodass 12 sperrt. Hierbei wird 30 über 31 wieder aufgeladen. Nach einer kurzen Zeit wird auf 15 wieder ein positives logisches Niveau stehen. Dadurch wird auf 18, über 32 und 33, ebenfalls dieses logische Niveau liegen, sodass 2 wieder schliesst. Das letzte hängt ab von der Tatsache, ob auf 16 ebenfalls ein positives Niveau steht.

Figur 5 gibt ein Beispiel für den elektronisch gesteuerten elektrischen Stromsicherungsautomaten. Dieser stimmt grösstenteils mit Figur 3 überein. Hier besteht ein Unterschied mit den Figuren 1 und 4. Figur 5 hat zusätzlich eine galvanische Stomtrennung. Diese galvanische Stromtrennung ist bistabil und aufgebaut mit Flip-Flop 34/35 sowie zwei NAND-Gatter beziehungsweise 34 und 35. Das Zurücksetzen dieser galvanischen bistabilen Funktion erfolgt über Tastknopf 39. Beim betätigen dieses Knopfes erfolgt über Kondensator 38 ein kurzer negativer Puls auf den betreffenden Eingang von 35. Dies bewirkt ein Umschalten des Flip-Flop 34/35, sodass auf 61 ein positives Niveau liegt. Dadurch schliesst Relais 23 über Transistor 42. Wenn jetzt der effektive Strom zwischen 1 und 8 zu gross ist, wird Komparator 12 über Widerstand 28 wieder leitend. Durch Komparator 12 wird auf 15 ein schnell senkendes Spannungsniveau erfolgen, wodurch Flip-Flop 34/35 umschaltet. Dies hat zur Folge, dass auf 61 für 42 keine Steuerspannung vorhanden ist und somit Relaiskontakt 50 öffnet. Bedingt durch Sicherheitsgründe, oder internationale Vorschriften, kann es notwendig sein, den Sicherheitsautomaten mit diesem galvanischen Trennsystem zu bestücken.

Bis jetzt ist über den Gebrauch des elektronisch gesteuerten elektrischen Stromsicherungsautomaten bei Gleichspannungsanwendungen gesprochen worden. Der Automat ist auch anwendbar bei Wechselstrom- und Drehstromnetzen.

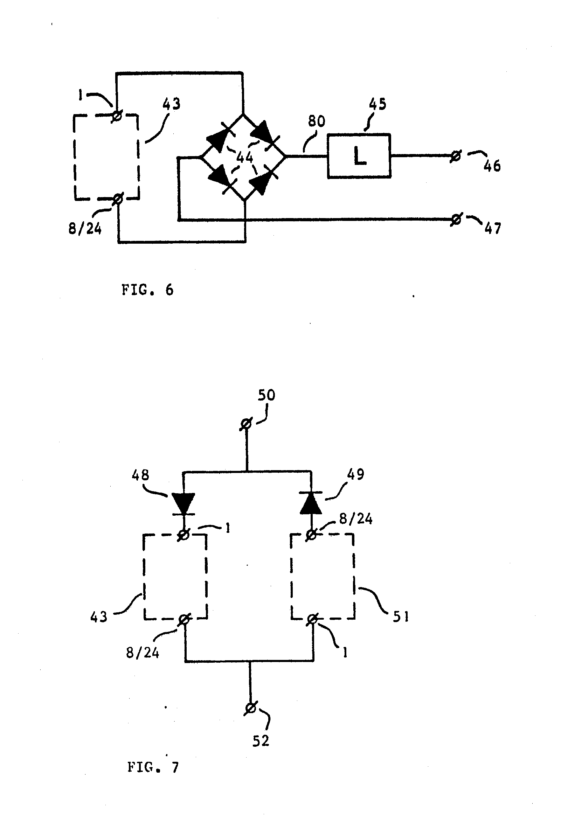

Figur 6 gibt ein Beispiel für eine Wechselstromanwendung. In dem unterstrichenen Teil 43 befindet sich, abhängig der Ausführung des elektronisch gesteuerten elektrischen Stromsicherungsautomaten, eine Schaltung laut den Figuren 1 bis einschliesslich 5. Die externen Anschlüsse 1, 8 und 24 in Figur 6 stimmen mit denselben Anschlüssen in Figur 1 bis einschliesslich 5 überein. Brückengleichrichter 44 in Figur 6 wandelt die Wechselspannung 80/47 in Gleichspannung um. 45 ist in Figur 6 eine willkürliche Wechselstromlast. Die Wechselspannung wird an den Punkten 46 un 47 angeschlossen.

Statt der Anwendung eines Brückengleichrichters 44 laut Figur 6, ist es auch bei Wechselspannung möglich, zwei nahezu identische Stromsicherungsautomaten, laut den Figuren 1 bis einschliesslich 5, zusammen mit zwei Gleichrichterdioden zu verwenden. Figur 7 gibt hierüber ein Beispiel. Der Wechselstrom eines Wechselstrom- oder Drehstromnetzes wird in Figur 7 zwischen den Punkten 50 und 52 angeschlossen. Abhängig von der Ausführung sind 43 und 51 Stromsicherungsautomaten, laut den Figuren 1 bis einschliesslich 5. Die externen Anschlüsse 1, 8 und 24 in Figur 7 stimmen mit denselben Anschlüssen in Figur 1 bis einschliesslich 5 überein. In Figur 7 wird der Wechselstrom für den Sicherungsautomaten 43 über die Diode 48 einphasig gleichgerichtet, während für den Sicherungsautomaten 51 die Gleichrichtung über Diode 49 erfolgt. Abhängig von der Anwendung kann in Figur 7 zwischen den Sicherungsautomaten 43 und 51 eine direkte oder indirekte Kopplung erfolgen. Dadurch wird der Sicherungsautomat, wenn er in einer Phasenhälfte in Tätigkeit tritt, auch in der anderen Phasenhälfte aktiviert. Eine derartige Kopplung ist aus der Literatur bekannt.

Es wird klar sein, dass bei der Konfiguration von Figur 6 und 7, für einen Wechsel- und Drehstromanschluss mehrere Varianten mit dem Sicherungsautomaten möglich sind. Dabei können Varianten der Figuren 1 bis einschliesslich 5 angebracht werden.

**PATENTANSPRÜCHE**

1. Elektronisch gesteuerter elektrischer Stromsicherungsautomat für Gleichstrom, Wechselstrom und Drehstrom **dadurch gekennzeichnet,** dass die Stromunterbrechung, die für die Sicherungsfunktion notwendig ist, bekommen wird in dem man einen Transistor (2) sperren lässt, wodurch der zu überwachende und zu sichernde Strom fliesst und wobei der genannte Transistor (2) analog auf Spitzenstrom und/oder Kurzschlussstrom gesichert wird mit Hilfe von minimal einem Spitzenstromsensor (7) und einem Komparator (21) und wobei der genannte Spitzenstromsensor (7), direkt oder indirekt, den genannten Komparator (21) ansteuert und wobei der Komparator (21), direkt oder indirekt, den genannten Transistor (2) ansteuert und wobei dieser Transistor (2) ebenfalls versehen ist mit einer elektronischen effektiven Stromabschaltfunktion, die minimal aus einem effektiven Stromsensor (4), einem Integrator (10), einem zweiten Komparator (12) und einem Zeitstromkreis (14) besteht, wobei der genannte effektive Stromsensor (4), direkt oder indirekt, den genannten Integrator ansteuert und der genannte Integrator (10), direkt oder indirekt, den genannten zweiten Komparator (12) ansteuert und der genannte zweite Komparator (12), direkt oder indirekt, den genannten Zeitstromkreis (14) ansteuert und wobei, während der Aktivierungszeit des Zeitstromkreises (14), dieser Stromkreis, direkt oder indirekt, dafür sorgt, dass der genannte Transistor zeitweilig sperrt, um damit die effektive Stromsicherung arbeiten zu lassen und auch dem Transistor (2) genügend Zeit zu geben, um im zeitweiligen gesperrten Zustand, thermisch abzukühlen.

2. Sowie Anspruch 1, **dadurch gekennzeichnet,** dass für den Transistor (2) mehrere Transistoren verwendet werden, die in Reihe oder parallel geschaltet sind, oder eine Kombination von Reihen- und Parallelschaltung von Transistoren sind.

3. Sowie Ansprüche 1 und 2, **dadurch gekennzeichnet,** dass für den Spitzenstromsensor (7) ein Widerstand oder ein Widerstandsstromkreis verwendet wird.

4. Sowie Ansprüche 1 und 2, **dadurch gekennzeichnet,** dass für den Spitzenstromsensor (7) ein Halbleiter oder eine Kombination von

0252541

Halbleitern verwendet wird.

5. Sowie Ansprüche 1 bis einschliesslich 4, **dadurch gekennzeichnet**, dass für die genannte effektive Stromabschaltfunktion ein anderer Transistor oder mehrere andere Transistoren, als die der analogen Spitzenstrombegrenzung, verwendet werden und die genannten analoge Spitzenstrombegrenzung und effektive Stromabschaltfunktion in verschiedenen Transistoren oder verschiedenen Transistorkombinationen untergebracht werden.

6. Sowie Ansprüche 1 bis einschliesslich 5, **dadurch gekennzeichnet**, dass für den effektiven Stromsensor (4) ein Widerstand oder Widerstandsstromkreis verwendet wird.

7. Sowie Ansprüche 1 bis einschliesslich 5, **dadurch gekennzeichnet**, dass der effektive Stromsensor (4) aus einem Halbleiter oder einer Kombination von Halbleitern besteht.

8. Sowie Ansprüche 1 bis einschliesslich 7, **dadurch gekennzeichnet**, dass der genannte Spitzenstromsensor (7) und der genannte effektive Stromsensor (4) den selben Komponent oder die selben Komponenten benutzen.

9. Sowie Ansprüche 1 bis einschliesslich 8, **dadurch gekennzeichnet**, dass der genannte Integrator (10) als Stromsicherung auf einen effektiven Stromwert gemeint ist.

10. Sowie Ansprüche 1 bis einschliesslich 9, **dadurch gekennzeichnet**, dass der Sicherungsautomat kombiniert wird mit einem galvanischen Stromunterbrechungssystem, das mit einer oder mehreren wiederherstellbaren Stromverbindungen wirkt.

11. Sowie Ansprüche 1 bis einschliesslich 10, **dadurch gekennzeichnet**, dass der Sicherungsautomat kombiniert wird mit einem galvanischen Stromunterbrechungssystem, das mit einer oder mehrerer nicht wiederherstellbaren galvanischen Stromverbindungen wirkt.

12. Sowie Ansprüche 1 bis einschliesslich 11, **dadurch gekennzeichnet**, dass der Sicherungsautomat ausserdem als Ein-/Ausschalter benutzt wird.

13. Sowie Ansprüche 1 bis einschliesslich 12, **dadurch gekennzeichnet,** dass die genannte elektronische effektive Stromabschaltfunktion mit willkürlichen Stromabschaltzeiten des Transistors (2) wirkt und wobei die Ansprechzeit der genannten elektronischen Stromabschaltfunktion sowie willkürlich oder nicht willkürlich ist.

14. Sowie Ansprüche 1 bis einschliesslich 13, **dadurch gekennzeichnet,** dass die genannte elektronische Stromabschaltfunktion eine Ansprechzeit hat die abhängig oder nicht abhängig ist von der Grösse der Überschreitung des nominal zugelassenen Sicherungsstromwerts.

15. Sowie Ansprüche 1 bis einschliesslich 14, **dadurch gekennzeichnet,** dass ein Komparator oder beide Komparatoren (21 und 12) gebrauch machen von Spannungs-, Strom- oder Zeitvergleich, oder einer Kombination von Spannungs- und/oder Strom- und/oder Zeitvergleich.

16. Sowie Ansprüche 1 bis einschliesslich 15, **dadurch gekennzeichnet,** dass die Stromabschaltwerte, die variabel sind als eine Funktion der Zeit, erhalten oder mit erhalten werden durch die Temperaturentwicklung, die verursacht wird durch den genannten Strom, in einer oder mehreren Komponenten des elektronisch gesteuerten elektrischen Stromsicherungsautomaten, verwendbar oder mit verwendbar, als physische Angabe die wesentlich ist für das Erhalten der genannten Stromabschaltwerten, die variabel sind als eine Funktion der Zeit.

0252541

FIG. 1

2|4

FIG. 2

FIG. 3

0252541

FIG. 4

FIG. 5

44

0252541

FIG. 6

FIG. 7

# EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | EP-A-0 075 656 (PORSCHE AG) <br> * Zusammenfassung, Figur * | 1,4,7 | H 02 H 3/087 |
| A | | 13-15 | |
| | --- | | |
| X | US-A-4 575 673 (R.R. TEDESCHI et al.) <br> * Spalte 2, Zeilen 3-23; Figur 3 * | 1,3,6, 12 | |
| A | | 13-15 | |
| | --- | | |
| A | US-A-4 110 809 (M.J. CRONIN) <br> * Figur 1 * | 2 | |
| | --- | | **RECHERCHIERTE SACHGEBIETE (Int Cl 4)** |
| A | DE-A-1 538 622 (GEORGE KENT LTD.) <br> * Seite 2, Figuren 1, 2 * | 4,7 | H 02 H 3/087 <br> H 02 H 3/093 |
| | --- | | |
| A | DE-B-1 763 282 (ELLENBERGER & POENSGEN) <br> * Anspruch 1; Figuren 1-3 * | 10,11 | |
| | --- | | |
| A | DE-B-2 207 791 (SIEMENS AG) <br> * Spalte 3, Zeile 15 - Spalte 4, Zeile 52; Figur * | 1 | |
| | ---     -/- | | |

Der vorliegende Recherchenbericht wurde für alle Patentansprüche erstellt.

| Recherchenort | Abschlußdatum der Recherche | Prüfer |
|---|---|---|
| BERLIN | 29-09-1987 | LEMMERICH J |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | GB-A-2 135 840 (WESTINGHOUSE ELECTRIC CORP.) <br> * Zusammenfassung, Figur * | 1 | |
| | --- | | |
| A | MOTOROLA TECHNICAL DISCLOSURE BULLETIN, Band 3, Nr. 1, März 1983, Seiten 23-24, Schaumburg, Illinois, US; M.M. STAMLER "Resettable current limit latch" <br> * Seiten 23-24 * | 1 | |
| | ----- | | |
| | | | RECHERCHIERTE SACHGEBIETE (Int Cl 4) |

Der vorliegende Recherchenbericht wurde für alle Patentansprüche erstellt.

| Recherchenort | Abschlußdatum der Recherche | Prüfer |
|---|---|---|
| BERLIN | 29-09-1987 | LEMMERICH J |